# EUROPEAN PATENT APPLICATION

(11) **EP 4 757 571 A2**
(43) Date of publication of application: **10.06.2026**
(21) Application number: 25210282.7
(22) Date of filing: 22.10.2025
(51) Int. Cl.: H10P 90/00, H10P 14/60

(54) **SILICON ON INSULATOR SUBSTRATE AND METHOD OF FORMING THE SAME**

(30) Priority: 18.11.2024 KR 20240163986
(71) Applicant: SK hynix Inc., Bubal-eub Icheon-si Gyeonggi-do 17336 (KR)
(72) Inventor: KIM, Il Do, 17336 Icheon-si (KR); LEE, Min Young, 17336 Icheon-si (KR); KIM, Seung Bum, 17336 Icheon-si (KR)
(74) Representative: Isarpatent

(57) **Abstract**

In a method of forming an SOI substrate, a stopper layer having an etch selectivity different from a first wafer may be formed on the first wafer having a first surface and a second surface facing each other. A semiconductor layer having an etch selectivity different from the stopper layer may be formed on the stopper layer. A buried insulation layer may be formed on the semiconductor layer. The buried insulation layer may be formed by applying a compressive stress condition, to have a height of a central portion of the buried insulation layer being formed higher than a height of an edge portion of the buried insulation layer.

## Description

### CROSS-REFERENCES TO RELATED APPLICATION

The present application claims priority under 35 U.S.C. § 119(a) to Korean application number 10-2024-0163986, filed on November 18, 2024, which is incorporated herein by reference in its entirety.

### BACKGROUND

### 1. Technical Field

Various embodiments of the present disclosure generally relate to a silicon on insulator (SOI) substrate and a method of forming the same, and more particularly to a SOI substrate configured to improve stress imbalance and a method of forming the SOI substrate.

### 2. Related Art

A semiconductor memory device, such as a DRAM (Dynamic Random Access Memory) device, may be required to have a high integration density while satisfying a high memory operation speed. However, a capacitor configured to perform memory operations in the DRAM device may be faced with a limitation of increasing capacity in a limited area of a chip.

To solve this problem, a semiconductor memory device utilizing a vertical channel transistor as a switching element is proposed. For example, the vertical channel transistor may be fabricated in a SOI substrate for a complete isolation between channels of adjacent vertical channel transistors which are formed in the SOI substrate.

Currently, a SOI substrate may be formed by bonding a donor wafer and a handle wafer to each other. Characteristics of the semiconductor memory device may depend on a bonding property of the donor wafer and handle wafer.

### SUMMARY

Various embodiments of the present disclosure provide a method of forming an SOI substrate that may relieve stress on a semiconductor layer by improving the bonding property between a donor wafer and a handle wafer.

Embodiments of the present disclosure also provide an SOI substrate fabricated by the above method of forming the SOI substrate.

According to an embodiment of the present disclosure, there is provided a method of forming an SOI substrate. In the method of forming the SOI substrate, a stopper layer may be formed on a first wafer having a first surface and a second surface facing each other. The stopper layer may have an etch selectivity that is different from that of the first wafer. A semiconductor layer having an etch selectivity that is different from that of the stopper layer may be formed on the stopper layer. A buried insulation layer may be formed on the semiconductor layer. The buried insulation layer may be formed by applying a compressive stress to the buried insulation layer to provide a central portion of the buried insulation layer with a height higher than a height of an edge portion of the buried insulation layer.

According to an embodiment of the present disclosure, there is provided a method of forming an SOI substrate. In the method of forming the SOI substrate, a stopper layer, a semiconductor layer, a buried insulation layer and a first bonding insulation layer may be sequentially formed on a first wafer to form a first structure. A second bonding insulation layer may be formed on a second wafer to form a second structure. The first structure may be bonded to the second structure to contact the first bonding insulation layer with the second bonding insulation layer. The first wafer and the stopper layer may be sequentially removed to transcribe the semiconductor layer onto the second structure. The buried insulation layer may be formed under a process condition such that a height of a central portion of the buried insulation layer may be higher than a height of an edge portion of the buried insulation layer.

According to an embodiment of the present disclosure, there is provided an SOI substrate. The SOI substrate may include a wafer, a bonding insulation layer, a buried insulation layer and a semiconductor layer. The bonding insulation layer may be formed on the wafer. The buried insulation layer may be formed on the bonding insulation layer. The semiconductor layer may be formed on the buried insulation layer.

In an embodiment of the present disclosure, the buried insulation layer may include a first TEOS insulation layer and a second TEOS insulation layer. The first TEOS insulation layer may contact the semiconductor layer. The first TEOS insulation layer may have a first thickness. The second TEOS insulation layer may be formed on a surface of the first TEOS insulation layer. The second TEOS insulation layer may have a second thickness that is different from that of the first thickness. A density of the second TEOS insulation layer may be greater than a density of the first TEOS insulation layer.

According to an embodiment of the present disclosure, the buried insulation layer may be formed on the first wafer under the conditions where the strong compressive stress may be provided. Accordingly, even if the buried insulation layer may be formed with a uniform thickness, due to the strong compressive stress, the buried insulation layer may be deformed such that the height of the central portion of the buried insulation layer may be higher than a height of an edge portion of the buried insulation layer. By a shape deformation of the buried insulation layer, a bonding efficiency of the central portion of the buried insulation layer may be improved when bonding the first wafer and the second wafer. Further, the buried insulation layer of an embodiment may include the TEOS insulation layer using a TEOS precursor with a high hydrogen content to ensure sufficient compressive stress. The TEOS insulation layer may be formed under relatively large compressive stress by performing the deposition process at a temperature of about 300°C to about 550°C, which may be higher than a process temperature of a general PEALD (Plasma Enhanced Atomic Layer Deposition) method. Furthermore, when depositing the TEOS insulation layer, a flow rate of a reaction source may be increased compared to the TEOS precursor to further increase the compressive stress.

Further, the buried insulation layer of an embodiment of the present disclosure may be formed in a dual plasma deposition chamber in which LF power and HF power may be supplied at least once alternately, thereby increasing the compressive stress. As described above, as the LF power and the HF power may be alternated at least once, the buried insulation layer may be formed in a structure in which an LF insulation layer and an HF insulation layer may be stacked at least once. In this case, the HF insulation layer may provide a relatively high density, which may strengthen the compressive stress. The LF insulation layer may improve the deposition rate while preventing residual oxygen atoms generated during the formation of the HF insulation layer from diffusing into the semiconductor layer. By forming the buried insulation layer by using the dual plasma deposition method, it is possible to secure sufficient compressive stress and deposition speed while preventing diffusion of oxygen components into the semiconductor layer.

### BRIEF DESCRIPTION OF THE DRAWINGS

The above and another aspects, features, and advantages of the subject matter of the present disclosure will be more easily understood from the following detailed description taken in conjunction with the accompanying drawings, in which:
FIGS. 1A to 1E are cross-sectional views illustrating a method of forming a first structure in accordance with an embodiment of the present disclosure;
FIG. 2 is a flow chart illustrating a method of forming a first structure in accordance with an embodiment of the present disclosure;
FIG. 3 is a cross-sectional view illustrating a plasma deposition apparatus configured to deposit a buried insulation layer in accordance with an embodiment of the present disclosure;
FIGS. 4A and 4B are cross-sectional views illustrating a buried insulating layer in accordance with an embodiment of the present disclosure;
FIG. 5 is a cross-sectional view illustrating a second structure in accordance with an embodiment of the present disclosure;
FIG. 6 is a flow chart illustrating a method of forming a second structure in accordance with an embodiment of the present disclosure;
FIGS. 7A to 7C are cross-sectional views illustrating a method of fabricating an SOI substrate, using a first structure and a second structure, in accordance with an embodiment of the present disclosure; and
FIG. 8 is a flow chart illustrating a method of fabricating an SOI substrate in accordance with an embodiment of the present disclosure.

### DETAILED DESCRIPTION

The advantages and features of the embodiments of the present disclosure, and methods of achieving them, will become apparent upon reference to the embodiments described in detail with reference to the accompanying drawings. The invention, however, is not limited to the embodiments disclosed herein, but may be implemented in many other different embodiments, forms, or variations of the described embodiments. These described embodiments are provided to make the disclosure of the invention complete, and to give those of ordinary skill in the art a complete idea of the technical concepts and scope of the embodiments, which are defined by the claims. The dimensions and relative sizes of the layers and regions in the drawings may be exaggerated for clarity of description. Throughout the specification, like reference numerals refer to like components.

A SOI substrate of an embodiment may be formed by bonding a first wafer including a semiconductor layer and a buried insulation layer to a second wafer. To improve the bonding characteristics of the first wafer and the second wafer, the buried insulation layer may be formed to have a compressive stress such that the central portion has a more convex shape than the edges. Accordingly, when bonding the first wafer and the second wafer, bonding may proceed from the central portion, thereby improving a bonding property between the first wafer and the second wafer.

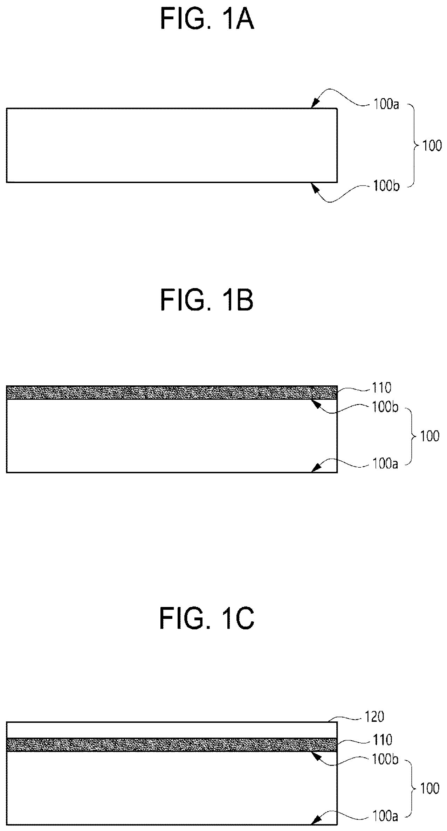

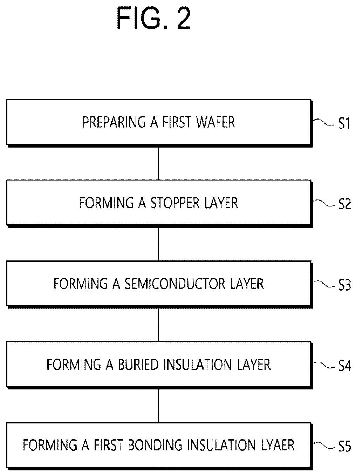

FIGS. 1A to 1E are cross-sectional views illustrating a method of forming a first structure in accordance with an embodiment of the present disclosure. FIG. 2 is a flow chart illustrating a method of forming a first structure in accordance with an embodiment of the present disclosure.

Referring to FIGS. 1A and 2, a first wafer 100 having a first surface 100a and a second surface 100b opposite to each other may be provided (S1). For example, the first wafer 100 may be a donor wafer that may be sacrificed and subsequently removed. The first wafer 100 may include at least one material of Si, Ge, SiC, IV-IV group, III-V group, or II-VI group semiconductor compounds, and piezoelectric materials, such as, for example, e.g., LiNbO3, LiTaO3, and the like.

Referring to FIGS. 1B and 2, a stopper layer 110 may be formed on the first surface 100a of the first wafer 100 (S2). The stopper layer 110 may be a layer which can prevent loss of a semiconductor layer to be subsequently formed when the first wafer 100 may be removed. Therefore, the stopper layer 110 may include a material having an etch selectivity with the first wafer 100. In addition, the stopper layer 110 may be formed of a semiconductor material having a property that is as small as possible compared to the semiconductor layer to be formed. In an embodiment of the present disclosure, the stopper layer 110 may be formed of a single crystalline SiGe layer. Furthermore, the stopper layer 110 may be formed with a thickness of 1nm to 100nm, to protect the semiconductor layer to be formed upon removal of the first wafer 100 in subsequent operations.

Referring to FIGS. 1C and 2, a semiconductor layer 120 may be formed on the stopper layer 110 (S3). In an embodiment, the semiconductor layer 120 may be a region in which a channel of a transistor in a semiconductor memory device may be formed. For example, the semiconductor layer 120 may include a single crystalline Si material.

In an embodiment of the present disclosure, the stopper layer 110 and the semiconductor layer 120 may be formed by an epitaxial growth process, using an in-situ process. For example, the semiconductor layer 120 may be formed to have a thickness of 5nm to 500nm, but the embodiments are not limited thereto.

For example, a lattice constant of the SiGe material used as the stopper layer 110 may be larger than a lattice constant of the Si material used as the semiconductor layer 120. Therefore, when the stopper layer 110 including the SiGe material and the semiconductor layer 120 including the Si material are epitaxially grown successively, the semiconductor layer 120 including the Si material may be grown under a first condition that gives a first compressive stress.

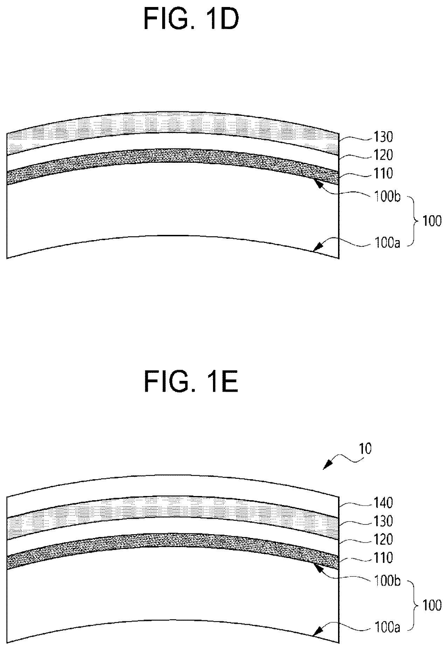

Next, referring to FIGS. 1D and 2, a buried insulation layer 130 may be formed on the semiconductor layer 120 (S4). The buried insulation layer 130 may be formed under a second condition that gives a second compressive stress greater than the first compressive stress. As the second compressive stress of the buried insulation layer 130 is greater than the first compressive stress of the semiconductor layer 120, the buried insulation layer 130 may be formed in such a way that a height of a central portion of the buried insulation layer 130 may be relatively higher than a height of an edge portion of the buried insulation layer 130.

The buried insulation layer 130 may be formed by changing at least one process condition, such as a process gas, a process method and a process temperature, to increase the compressive stress of the buried insulation layer 130.

In an embodiment of the present disclosure, the buried insulation layer 130 may be formed using a plasma enhanced tetraethyl orthosilicate (PETEOS) precursor having a relatively high hydrogen content to form a TEOS insulation layer. Further, the TEOS insulation layer may be formed by a plasma deposition to give a higher compressive stress. Further, the TEOS precursor may include a larger amount of hydrogen than a SixHy series of gases, such as a silane gas. Therefore, when the TEOS precursor having the higher hydrogen content is used as a source gas the compressive stress is increased compared to when the SixHy gas is used as the source gas. However, it may be possible to increase a supply ratio of the silane gas, or to use the SixHy series gases such as the monosilane, the disilane, or the trisilane with the hydrogen content adjusted to the level of the TEOS precursor.

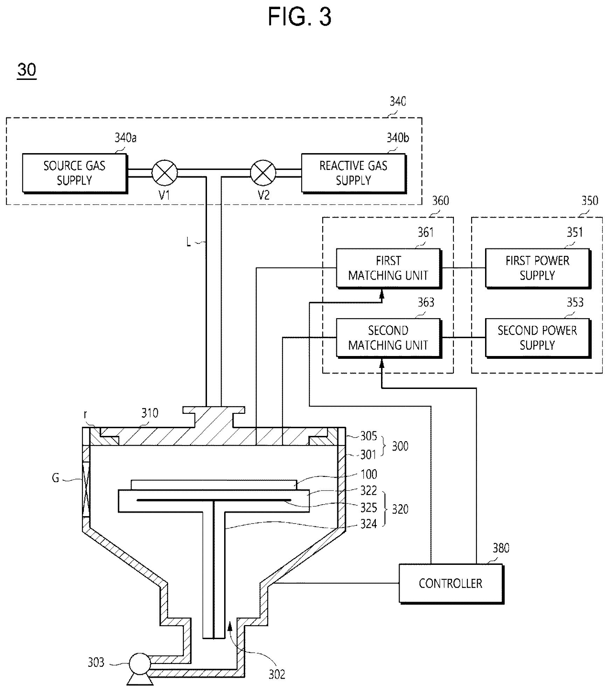

FIG. 3 is a cross-sectional view illustrating a plasma deposition apparatus configured to deposit a buried insulation layer in accordance with an embodiment of the present disclosure.

Referring to FIG. 3, a plasma deposition apparatus 30 may include a plasma deposition chamber 300, a shower head 310, a substrate supporting block 320 and a plasma power supply 350. In addition, the plasma deposition apparatus 30 may further include a gas supply 340, a matching network 360 and a controller 380. In an embodiment, the plasma deposition apparatus 30 may include a plasma enhanced atomic layer deposition (PEALD) chamber or a plasma enhanced chemical vapor deposition (PECVD) chamber.

The plasma deposition chamber 300 may include a main body 301 and a top lid 305. The main body 301 may define a space for depositing a thin layer on a wafer. The main body 301 may have an open top. The top lid 305 may be installed on a top periphery of the main body 301. The top lid 305 may have a cover shape having a window (not shown) into which the showerhead 310 may be inserted. The main body 301 may be provided with a gate G on a side surface of the main body 301 configured to allow for the wafer to be loaded or unloaded through the gate G.

The plasma deposition apparatus 30 may further include an exhaust vent 302 connected to the plasma deposition chamber 300 and a pump 303 connected to the exhaust vent 302. The pump 303 may vacuum an interior of the plasma deposition chamber 300 and may evacuate process residues in the plasma deposition chamber 300.

The showerhead 310 may be connected with the gas supply 340 to inject a source gas and a reactive gas onto the first wafer 100 on the substrate supporting block 320. In an embodiment of the present disclosure, the shower head 310 may be electrically connected with the power supply 350 to act as a first electrode for generating the plasma.

The substrate supporting block 320 may include a susceptor 322 and a support shaft 324. The susceptor 322 may have an overall flat plate shape to support at least one first wafer 100. The support shaft 324 may be perpendicularly coupled to a rear of the susceptor 322. The support shaft 324 may be provided with a drive force to raise, lower, and/or rotate the susceptor 322. In an embodiment of the present disclosure, the susceptor 322 may include a heater 325. The heater 325 may be suitable for adjusting a temperature of the first wafer 100 to be processed. Further, the substrate supporting block 320 may receive a ground voltage to act as a second electrode for generating the plasma.

For example, the gas supply 340 may include at least one source gas supply 340a and at least one reactive gas supply 340b.

For example, the source gas supply 340a may include a TEOS precursor. Alternately, in another embodiment, the source gas may include the SixHy series, such as the monosilane, the disilane, the tricilane, and the like, with hydrogen content adjusted to the level of the TEOS precursor.

The reactive gas supply 340b may include a gas including oxygen gas, for example, an O₂ gas or N₂O source.

The gas supply 340 may be connected with the showerhead 310 via a gas supply line L. At least one valve V1 and V2 may be installed in the gas supply line L connecting with the at least one source gas supply 340a and the at least one reactive gas supply 340b, respectively. The valves V1 and V2 may regulate the supply of the gases in the gas supply lines 340.

The plasma power supply 350 may include a first power supply 351 and a second power supply 353.

For example, the first power supply 351 may provide a high frequency (hereinafter, HF) power having a center frequency band of about 10MHz to about 40MHz, such as about 13.56MHz, to the plasma deposition chamber 300, such as the showerhead 310.

The second power supply 353 may provide a low frequency (hereinafter, LF) power having a center frequency band of about 300 kHz to about 500 kHz, such as 370 KHz, to the plasma deposition chamber 300, such as the shower head 310.

For example, the plasma deposition apparatus 30 of an embodiment may be a dual plasma deposition apparatus with different powers applied.

The matching network 360 may include a first matching unit 361 and a second matching unit 363. The first matching unit 361 may be connected between the first power supply 351 and the showerhead 310. The first matching unit 361 may mutually match an output impedance of the first power supply 351 and a load impedance of the plasma deposition chamber 300. The second matching unit 362 may be connected between the second power supply 353 and the showerhead 310, which may mutually match an output impedance of the second power supply 353 and the load impedance of the plasma deposition chamber 300. Accordingly, reflection losses of the HF power source and the LF power source may be reduced.

The controller 380 may be configured to control the overall operations of the plasma deposition apparatus 30. For example, the controller 380 may control the operation of each of the components 310 to 360, and the valves V1 and V2 of the plasma deposition apparatus 30.

More specifically, the controller 380 may control both the type of the source gas, the amount of the flow rate of the source gas in the gas supply 340 for forming a thin layer on the first wafer 100, as well as the process conditions in the plasma deposition chamber 300 for forming the thin layer.

In an embodiment of the present disclosure, if the plasma deposition apparatus 30 includes the PEALD chamber, the buried insulating layer 130 may be formed by injecting a TEOS precursor as the source gas at a constant flow rate to adsorb onto a surface of the resulting product, purging unabsorbed TEOS components, supplying a reactive gas to react with the adsorbed TEOS components, and purging unreacted reactive gas components.

To further increase the compressive stress of the buried insulating layer 130, a reactive gas for decomposing the TEOS source may be at least one of O₂ and N₂O.

For example, the reactive gas may be supplied at a relatively high flow rate relative to the source gas (e.g., TEOS precursor), e.g., about 1 time to about 10 times, for example, 6,000 to 11,000 sccm (standard cubic centimeters per minute). As such, by increasing the flow rate of the reactive gas relative to the source gas, the compressive stress may be further enhanced.

In an embodiment of the present disclosure, when the buried insulation layer 130 is formed of a PETEOS insulation layer, the buried insulation layer 130 is deposited at a temperature of about 300°C to about 550°C, which may be higher than a typical deposition temperature range of about 100°C to about 250°C for the PEALD. The increase in a deposition temperature may increase the decomposition efficiency of the source gas and reactive gas, thereby increasing the density of the buried insulation layer 130, which may further increase the compressive stress. For example, the deposition temperature may be adjusted by a heater 325 in the susceptor 322.

Furthermore, to generate a plasma in the space of the plasma deposition chamber 300, an inert gas, for example, a He gas may be supplied to the plasma deposition chamber 300, to increase the compressive stress of the buried insulation layer 130.

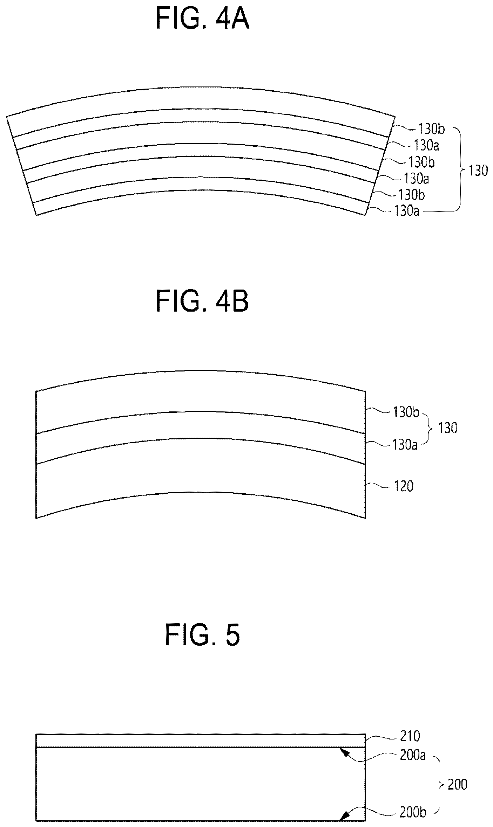

FIGS. 4A and 4B are cross-sectional views of a buried insulating layer in accordance with an embodiment of the present disclosure.

Referring to FIGS. 3, 4A and 4B, the buried insulation layer 130 may include an LF insulation layer 130a and an HF insulation layer 130b stacked at least once alternately.

For example, the LF power and HF power may be alternately supplied to the showerhead 310 by controlling the plasma power supply 350 to alternately deposit the LF insulation layer 130a and HF insulation layer 130b at least once.

For example, the LF power may have a range of about 500 Watts to about 5,000 Watts. The LF insulation layer 130a, which is formed by applying the LF power to the showerhead 310, may be more porous than the HF insulation layer 130b. The LF insulation layer 130a having the porosity may prevent cracking of the buried insulation layer 130. The LF insulation layer 130a may prevent the reactive gas components (e.g., oxygen components) from diffusing into the semiconductor layer 120.

For example, the HF power may have a range of about 1,000 Watts to about 5,000 Watts. As the plasma potential in the plasma deposition chamber 300 is increased by the HF power, an ion bombardment phenomenon may also be increased. Therefore, the HF insulation layer 130b may have an increased density compared to the LF insulation layer 130a and as a result a relatively higher compressive stress compared to the LF insulation layer 130a.

In an embodiment of the present disclosure, as shown in FIG. 4A, the buried insulation layer 130 may include the LF insulation layer 130a (LF TEOS insulation layer) and the HF insulation layer 130b (HF TEOS insulation layer) alternately and repeatedly stacked. For example, a thickness of the HF insulation layer 130b may be formed to be thicker than a thickness of the LF insulation layer 130a so that the buried insulation layer 130 as a whole may have a compressive stress. Further, the LF insulation layers 130a interposed between the HF insulation layers 130b, or between the HF insulation layer 130b and the semiconductor layer (not shown), may complement a deposition rate of the buried insulation layer 130 as a whole, and may prevent residual reactive gas components from diffusing toward the semiconductor layer 120 upon a deposition of the HF insulation layer 130b.

In an embodiment of the present disclosure, as shown in FIG. 4B, the buried insulation layer 130 may include the LF insulation layer 130a formed to have a first thickness on the semiconductor layer 120 and an HF insulation layer 130b formed to have a second thickness on the LF insulation layer 130a that is greater than the first thickness. Since the HF insulation layer 130b may be formed thicker than the LF insulation layer 130a, the compressive stress of the buried insulation layer 130 may be increased. Furthermore, the LF insulation layer 130a may be interposed between the HF insulation layer 130b and the semiconductor layer 120, and the diffusion of the reactive gas components may be blocked when the HF insulation layer 130b is formed.

Forming the buried insulation layer 130 in the above manner, allows the height of a central portion of the buried insulation layer 130 to be higher than the height of an edge portion of the buried insulation layer 130. Accordingly, bonding voids may be reduced in a subsequent wafer bonding process for bonding wafers.

Thereafter, with reference to FIGS. 1E and 2, a first bonding insulation layer 140 may be formed over the buried insulation layer 130 having a relatively large second compressive stress, as described above (S5), to form a first structure 10. The first bonding insulation layer 140 may include at least one of SiCN, SiO2, and Si3N4. However, various insulation layers having a bonding property may be included herein.

In an embodiment of the present disclosure, the first bonding insulation layer 140 may be formed along a shape of the buried insulation layer 130. Since, the height of the central portion of the buried insulation layer 130 is higher than the height of the edge portion of the buried insulation layer 130, the first bonding insulation layer 140 may also have a height of a central portion higher than an edge portion in the first bonding insulation layer140.

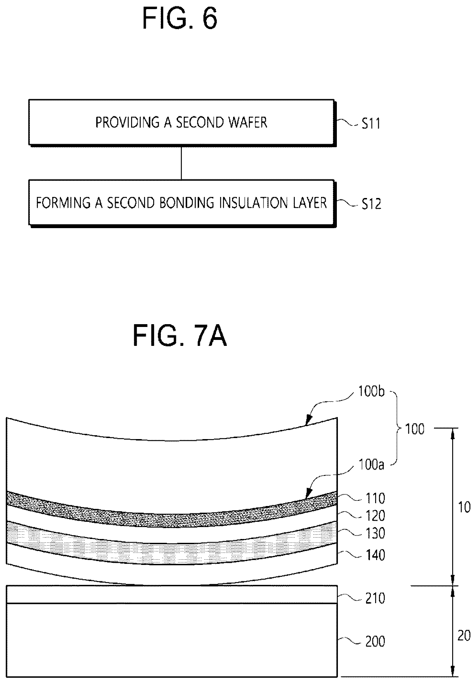

FIG. 5 is a cross-sectional view illustrating a second structure in accordance with an embodiment of the present disclosure, and FIG. 6 is a flow chart illustrating a method of forming a second structure in accordance with an embodiment of the present disclosure.

Referring to FIGS. 5 and 6, a second wafer 200 may be prepared (S11). The second wafer 200 may include a first surface 200a and a second surface 200b that face each other. For example, the second wafer 200 may include a carrier substrate. The second wafer 200 may include at least one of Si, SiC, glass, sapphire, AIN, or other materials available in the substrate.

A second bonding insulation layer 210 may be formed over the first surface 200a of the second wafer 200 to form a second structure 20 (S12). The second bonding insulating layer 210 may include a material suitable for bonding with the first bonding insulating layer 140, such as, an insulating layer having the same or substantially the same coefficient of thermal expansion as the first bonding insulating layer 140. In an embodiment of the present disclosure, the second bonding insulation layer 210 may include at least one of SiCN, SiO2, and Si3N4, which is the same or substantially the same as the first bonding insulation layer 140.

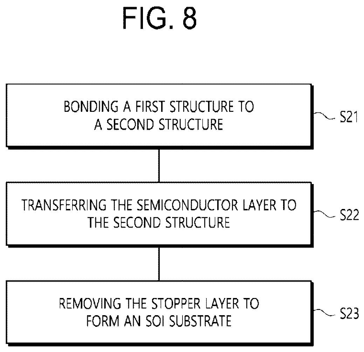

FIGS. 7A to 7C are cross-sectional views illustrating a method of fabricating an SOI substrate, using a first structure and a second structure, in accordance with an embodiment of the present disclosure. FIG. 8 is a flow chart illustrating a method of fabricating an SOI substrate in accordance with an embodiment of the present disclosure.

Referring to FIGS. 7A and 8, the first structure 10 may be stacked on the second structure 20 so that the first bonding insulation layer 140 of the first structure 10 and the second bonding insulation layer 210 of the second structure 20 may face each other. Then, an upper surface of the first structure 10, such as a second surface 100b of the first wafer 100, may be pressurized to bond the first bonding insulation layer 140 to the second bonding insulation layer 210, thereby bonding the first structure 10 to the second structure 20 (S21). A reference numeral 220 indicates a bonding layer formed by bonding together the first bonding insulating layer 140 and the second bonding insulating layer 210.

In an embodiment of the present disclosure, the bonding process of the first structure 10 and the second structure 20 may be performed by direct bonding including molecular adhesion or the like, hot pressing, or electrostatic bonding, but the embodiments are not limited thereto.

As described above, as the buried insulation layer 130 may be applied to the high compressive stress, the height of the central portion of the first bonding insulation layer 140 formed along the surface of the buried insulation layer 130 may increase relative to the height of the edge portion of the first bonding insulation layer 140. That is, by the compressive stress of the buried insulation layer 130, the shape of the first structure 10 may be deformed and adjusted to a form that facilitates the bonding with the second structure 20. As the bonding proceeds from the center of the wafer, bonding voids at the edge of the wafer may be improved.

In an embodiment of the present disclosure, before the bonding process of the first structure 10 and the second structure 20, a surface of the first bonding insulation layer 140 of the first structure 10 and a surface of the second bonding insulation layer 210 of the second structure 20 may be cleaned.

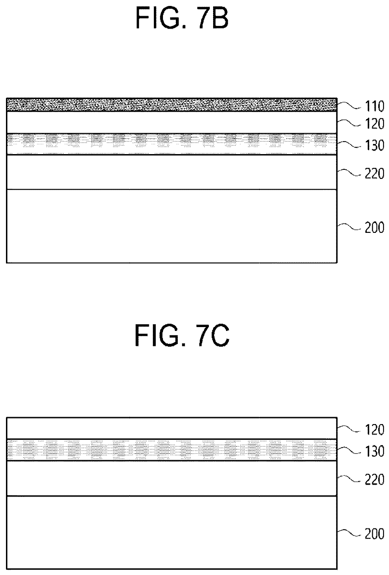

Referring to FIGS. 7B and 8, the first wafer 100 of the first structure 10 may be removed to expose the stopper layer 110. The first wafer 100 may be selectively removed by a smart cutting method. The smart cutting methods may include, for example, laser cutting, plasma etching, or mechanical scribing. Smart cutting ensures a clean and accurate separation without causing damage to the remaining structures. Alternatively, the first wafer 100 may be selectively removed using an annealing and grinding method. Further, the first wafer 100 may be selectively removed using an annealing, grinding, and chemical mechanical polishing (CMP) process.

As the first wafer 100 may be selectively removed, the semiconductor layer 120 located on the first wafer 100 may be transferred onto the second structure 20 (S22).

Referring to FIGS. 7C and 8, the stopper layer 110 may be optionally removed to form the SOI substrate (S23).

In an embodiment of the present disclosure, the stopper layer 110 may include a SiGe material having a different etch selectivity than the semiconductor layer 120 including a Si material, as described above, so that it can be selectively removed using a plasma etching process. However, various etching processes may be included herein without affecting the properties of the semiconductor layer 120.

Thereafter, although not shown in the drawings, various semiconductor devices may be fabricated within the semiconductor layer 120 of the SOI substrate, such as a three-dimensional semiconductor device having vertical channels.

According to an embodiment of the present disclosure, the buried insulation layer formed on the first wafer may be formed under conditions where the strong compressive stress may be provided. Accordingly, even if the buried insulation layer may be formed with a uniform thickness, due to the strong compressive stress, the buried insulation layer may be deformed such that the height of the central portion of the buried insulation layer may be in the form of the height of the edge portion of the buried insulation layer. Due to the shape deformation of the buried insulation layer, when bonding the first and second wafers, the bonding proceeds from the center of the first and second wafers, which may effectively reduce or fully prevent formation of any bonding voids, including at the edges of the first and second wafers.

Further, the buried insulation layer of an embodiment may include the TEOS insulation layer using the TEOS precursor with the high hydrogen content to ensure the sufficient compressive stress. The TEOS insulation layer may be deposited under the relatively large compressive stress by performing the deposition process at a temperature of 300°C to 550°C, which may be higher than the process temperature of the general PEALD process. Furthermore, when depositing the TEOS insulation layer, the flow rate of the reactive gas may be increased compared to the TEOS precursor to further increase the compressive stress.

Moreover, the buried insulation layer of an embodiment may be formed in the dual plasma deposition chamber in which the LF power and the HF power may be alternately supplied at least once, thereby increasing the compressive stress. Hence, as described above, as the LF power and HF power may be alternated at least once, the buried insulation layer may be formed in the structures in which the LF insulation layer and the HF insulation layer are stacked at least once. Thus, the HF insulation layer may provide the relatively high density, which may strengthen the compressive stress. The LF insulation layer may improve the deposition rate while preventing the residual oxygen atoms generated during the formation of the HF insulation layer from diffusing into the semiconductor layer. By forming the buried insulation layer by this dual plasma deposition process, it is possible to secure sufficient compressive stress and deposition speed while preventing the diffusion of the oxygen gas into the semiconductor layer.

While the present disclosure has been described in detail with reference to various embodiments, the invention is not limited to the above embodiments. Many modifications may be envisioned by those having ordinary skill in the art, which fall within the scope of the present disclosure. Furthermore, the embodiments may be combined to form additional embodiments.

## Claims

1. A method of forming a silicon on insulator (SOI) substrate, the method comprising:
providing a first wafer including a first surface and a second surface which are opposite to each other;
forming a stopper layer on the first wafer, the stopper layer having an etch selectivity different from that of the first wafer;
forming a semiconductor layer on the stopper layer, the semiconductor layer having an etch selectivity different from that of the stopper layer; and
forming a buried insulation layer on the semiconductor layer,
wherein the buried insulation layer is deposited under compressive stress with a height of a central portion of the buried insulation layer being formed higher than a height of an edge portion of the buried insulation layer.

2. The method of claim 1, wherein the stopper layer comprises a SiGe layer, and
wherein the semiconductor layer comprises a single crystalline Si layer.

3. The method of claim 1, wherein forming the stopper layer comprises forming a SiGe layer by an epitaxial growth process based on the first wafer, and
wherein forming the semiconductor layer comprises forming a Si layer by the epitaxial growth process based on the stopper layer.

4. The method of claim 1, wherein forming the buried insulation layer comprises forming a TEOS insulation layer using a TEOS precursor and a reactive gas including an oxygen gas.

5. The method of claim 4, wherein a flow rate of the reactive gas including the oxygen gas is supplied in an amount 1 to 10 times greater than the TEOS precursor.

6. The method of claim 1, wherein the buried insulation layer is formed in a plasma deposition chamber.

7. The method of claim 6, wherein forming the buried insulation layer comprises applying a low frequency (LF) power and a high frequency (HF) power to the plasma deposition chamber at least once alternately.

8. The method of claim 6, wherein forming the buried insulation layer comprises:
applying a LF power to the plasma deposition chamber, to deposit a LF insulation layer having a first thickness on the semiconductor layer; and
applying a HF power to the plasma deposition chamber, to deposit a HF insulation layer having a second thickness that is different from the first thickness on the LF insulation layer.

9. The method of claim 8, wherein the second thickness is greater than the first thickness.

10. The method of claim 1, wherein the buried insulation layer is formed by a plasma enhanced atomic layer deposition (PEALD) at a temperature of 300 °C to 550 °C.

11. The method of claim 1, further comprising:
forming a first bonding insulation layer over the buried insulation layer, to form a first structure;
forming a second bonding insulation layer on a second wafer, to form a second structure;
stacking the first structure on the second structure to face the first bonding insulation layer and the second bonding insulation layer;
bonding the second structure to the first structure;
removing the first wafer of the first structure; and
selectively etching the stopper layer.

12. A method of forming an SOI substrate, the method comprising:
forming a first structure by sequentially depositing a stopper layer, a semiconductor layer, a buried insulation layer and a first bonding insulation layer on a first wafer;
forming a second structure by forming a second bonding insulation layer on a second wafer;
bonding the first structure to the second structure to contact the first bonding insulation layer with the second bonding insulation layer; and
transferring the semiconductor layer onto the second structure by sequentially removing the first wafer and the stopper layer,
wherein the buried insulation layer is formed under at least one process conditions to have a height of a central portion of the buried insulation layer being higher than a height of an edge portion of the buried insulation layer.

13. The method of claim 12, wherein depositing the buried insulation layer comprises:
loading the first wafer on which the semiconductor layer is formed into a plasma deposition chamber;
applying a low frequency (LF) power to the plasma deposition chamber, to deposit a LF TEOS insulation layer on the semiconductor layer; and
applying a high frequency (HF) power into the plasma deposition chamber, to deposit a HF TEOS insulation layer on the LF TEOS insulation layer,
wherein the LF TEOS insulation layer and the HF TEOS insulation layer are alternately deposited at least once.

14. The method of claim 13, wherein the LF TEOS insulation layer and the HF TEOS insulation layer are deposited to have different thicknesses.

15. The method of claim 12, wherein the buried insulation layer is formed of a TEOS insulation layer,
wherein the TEOS insulation layer is formed by supplying a TEOS precursor as a source gas and a reactive gas including an oxygen gas, and
wherein a flow rate of the reactive gas including the oxygen gas is supplied in an amount 1 to 10 times greater than the TEOS precursor.

16. The method of claim 15, wherein the TEOS insulation layer is formed by a plasma enhanced atomic layer deposition (PEALD) process at a temperature of about 300°C to about 550°C.

17. An SOI substrate comprising:
a wafer;
a bonding insulation layer formed over the wafer;
a buried insulation layer formed over the bonding insulation layer; and
a semiconductor layer formed on the buried insulation layer,
wherein the buried insulation layer comprises:
a first TEOS insulation layer configured to make contact with the semiconductor layer and having a first thickness; and
a second TEOS insulation layer formed on a surface of the first TEOS insulation layer, the second TEOS insulation layer having a second thickness different from the first thickness, and
wherein a density of the second TEOS insulation layer is greater than a density of the first TEOS insulation layer.

18. The SOI substrate of claim 17, wherein the first TEOS insulation layer and the second TEOS insulation layer are alternately stacked in at least once.

19. An SOI substrate comprising:
a wafer;
a bonding insulation layer formed over the wafer;
a buried insulation layer formed over the bonding insulation layer; and
a semiconductor layer formed on the buried insulation layer,
wherein the buried insulation layer comprises:
a first insulation layer configured to contact the semiconductor layer;
and
a second insulation layer formed on a surface of the first insulation layer,
wherein a thickness of the second insulation layer is greater than a thickness of the first insulation layer.
